# EUROPEAN PATENT APPLICATION

(11) **EP 3 993 070 A1**
(43) Date of publication of application: **04.05.2022**
(21) Application number: 20926397.9
(22) Date of filing: 24.08.2020
(51) Int. Cl.: H01L 33/46, H01L 33/00, H01L 33/48, B82Y 30/00, B82Y 40/00

(54) **INVERTED DEEP ULTRAVIOLET LED OF DOUBLE-LAYER PHOTONIC CRYSTAL STRUCTURE, AND PREPARATION METHOD THEREFOR**

(30) Priority: 25.03.2020 CN 202010216331
(71) Applicant: Suzhou Uvcantek Co., Ltd, Suzhou, Jiangsu 215000 (CN)
(72) Inventor: ZHANG, Jun, Suzhou, Jiangsu 215000 (CN); YUE, Jinshun, Suzhou, Jiangsu 215000 (CN); LIANG, Renli, Suzhou, Jiangsu 215000 (CN)
(74) Representative: Ipside
(86) International application number: PCT/CN2020/110869
(87) International publication number: WO 2021/189763

(57) **Abstract**

The invention discloses an inverted deep ultraviolet LED with double-layer photonic crystal structure and preparation method therefor. The an inverted deep ultraviolet LED with double-layer photonic crystal structure comprises a frame, a deep ultraviolet LED chip and a lens;the lens is arranged on the top of the frame, and the deep ultraviolet LED chip is arranged in a closed space enclosed by the frame and the lens;the deep ultraviolet LED chip is arranged at the bottom of the frame, and a first nano array structure is arranged on the surface of the deep-ultraviolet LED chip near the bottom of the frame, and a second nano array structure is arranged on the surface of the deep ultraviolet LED chip away from the bottom of the frame. The beneficial effect of the technical scheme proposed in the present invention is: by arranging the first nano array structure on the P-type GaN contact layer and the second nano array structure on the sapphire substrate of the deep ultraviolet LED, the existing upper limit of light extraction efficiency is broken, and the optical power of deep ultraviolet LED is more than doubled.

## Description

### Technical Field

The disclosure relates to an inverted deep ultraviolet LED with double-layer photonic crystal structure and preparation method thereof.

### Background of the Invention

Deep ultraviolet LED has been widely used in disinfection, sterilization, air purification, food preservation and other fields. However, in terms of the performance of deep ultraviolet LEDs, due to the lower light efficiency (it is usually less than 5% and varies with wavelength), especially the limitation of light extraction efficiency; on the one hand, the performance of deep ultraviolet LEDs is far from mature commercial blue LEDs; on the other hand, the LED generates a lot of heat during use, which affects its life and stability. For the 280 nm deep ultraviolet LED, the light extraction efficiency is still below 10%, and the light loss mainly comes from the total reflection inside the chip and the absorption of the metal electrode material. Therefore, if some methods are used to improve the extraction efficiency of UV LEDs, the performance and life of UV LEDs can be effectively improved.

The photonic crystal structure is a direct and effective method to improve the extraction efficiency of deep ultraviolet light. The preparation process is not complicated, and it can be obtained by dry etching, wet etching and other methods. Studies have shown that the P-type GaN material on the top layer has strong absorption, and the sapphire / air interface will produce total reflection of deep ultraviolet light. These factors greatly limit the light extraction efficiency of ultraviolet LEDs. Therefore, a new ultraviolet LED design needs to be proposed for solving the current problem.

### Summary of the Invention

The purpose of the present invention is to provide an inverted deep ultraviolet LED with double-layer photonic crystal structure and preparation method thereof, for solving the problems of the strong absorption of deep ultraviolet light by the P-type GaN contact layer and the total reflection of deep ultraviolet light at the sapphire / air interface in the prior art.

The inverted deep ultraviolet LED with double-layer photonic crystal structure comprises a frame, a deep ultraviolet LED chip and a lens; wherein the lens is arranged on the top of the frame, and the deep ultraviolet LED chip is arranged in a closed space enclosed by the frame and the lens.

The preparation method of inverted deep ultraviolet LED with double-layer photonic crystal structure, including the following steps: the LED chip epitaxial growth, the preparation of first nano array structure, the preparation of LED chip electrode, the preparation of second nano array structure and packaging.

The specific steps of the LED chip epitaxial growth are as follows: using the MOCVD method to sequentially deposit an AIN buffer layer, a superlattice layer, a N-type AIGaN electron transport layer, a quantum well active layer, and a P-type hole transport layer and the P-type GaN contact layer on a sapphire substrate for obtaining the LED epitaxial wafer.

The preparation method of inverted deep ultraviolet LED with double-layer photonic crystal structure is used to prepare the inverted deep ultraviolet LED with double-layer photonic crystal structure above.

The beneficial effect of the technical scheme proposed in the present invention is: by arranging the first nano array structure on the P-type GaN contact layer and the second nano array structure on the sapphire substrate of the deep ultraviolet LED, the existing upper limit of light extraction efficiency is broken, and the optical power of deep ultraviolet LED is more than doubled.

### Brief description of the Drawings

Accompanying drawings are for providing further understanding of embodiments of the disclosure. The drawings form a part of the disclosure and are for illustrating the principle of the embodiments of the disclosure along with the literal description. Apparently, the drawings in the description below are merely some embodiments of the disclosure, a person skilled in the art can obtain other drawings according to these drawings without creative efforts. In the figures:
FIG. 1 is a schematic diagram of the inverted deep ultraviolet LED with double-layer photonic crystal structure;
FIG. 2 is a schematic diagram of the structure of the deep ultraviolet LED chip in the inverted deep ultraviolet LED with double layer photonic crystal structure;
FIG. 3 is a schematic diagram of the structure of the first nano array structure and the second nano array structure in the inverted deep ultraviolet LED with double-layer photonic crystal structure;
FIG. 4 is a flow chart of the preparation method of inverted deep ultraviolet LED with double-layer photonic crystal structure;
FIG. 5 is a schematic diagram of the light emission of the inverted deep ultraviolet LED with double-layer photonic crystal structure: *a* is an ordinary deep-ultraviolet LED chip, and *b* is an inverted deep ultraviolet LED chip with double-layer photonic crystal structure;
FIG. 6 is a comparison diagram of the optical power of an inverted deep ultraviolet LED with double-layer photonic crystal structure and an ordinary deep ultraviolet LED.

### Detailed Description of Embodiments

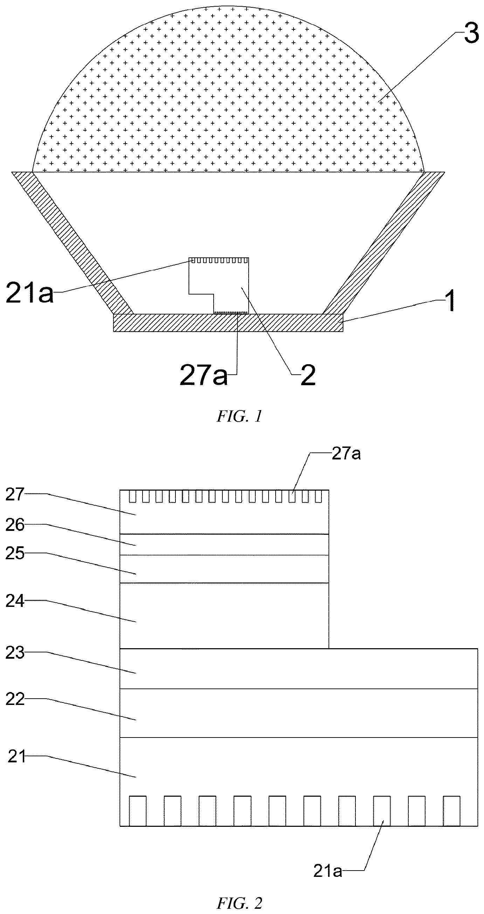

For the first solution provided by the present invention, it is provided a temperature-resistant and anti-collapse multi-branched polymer fluid loss reducer, please refer to FIG. 1 to FIG. 3. The inverted deep ultraviolet LED with double-layer photonic crystal structure comprises a frame (1), a deep ultraviolet LED chip (2) and a lens (3), wherein the lens (3) is arranged on the top of the frame (1), and the deep ultraviolet LED chip (2) is arranged in a closed space enclosed by the frame (1) and the lens (3); the deep ultraviolet LED chip (2) is arranged at the bottom of the frame (1), and a first nano array structure (27a) is arranged on the surface of the deep ultraviolet LED chip (2) near the bottom of the frame (1), and a second nano array structure (21a) is arranged on the surface of the deep ultraviolet LED chip (2) away from the bottom of the frame (1).

In this embodiment, the first nano array structure (27a) is an array structure with a number of cylindrical grooves, the cylindrical grooves have a diameter of 200 ~ 400 nm and a depth of 150 ~ 250 nm, and the adjacent cylindrical grooves are arrayed in a regular triangle, and the distance between the centers of adjacent cylindrical grooves is 800 ~ 1500 nm. The second nano array structure (21 a) is an array structure with a number of cylindrical grooves, the cylindrical grooves have a diameter of 450 ~ 750 nm and a depth of 500 ~ 1000 nm, and the adjacent cylindrical grooves are arrayed in a regular triangle, and the distance between the centers of adjacent cylindrical grooves is 800 ~ 1500 nm.

In this embodiment, the deep ultraviolet LED chip (2) includes a sapphire substrate (21), an AIN buffer layer (22), a superlattice layer (23), a N-type AIGaN electron transport layer (24), a quantum well active layer (25), a P-type hole transport layer (26), and a P-type GaN contact layer (27). Depositing the AIN buffer layer (22), the superlattice layer (23), the N-type AIGaN electron transport layer (24), the quantum well active layer (25), the P-type hole transport layer (26), and the P-type GaN contact layer (27) sequentially on the sapphire substrate (21). The first nano array structure (27a) is arranged on the P-type GaN contact layer (27), and the second nano array structure (21a) is arranged on the sapphire substrate (21).

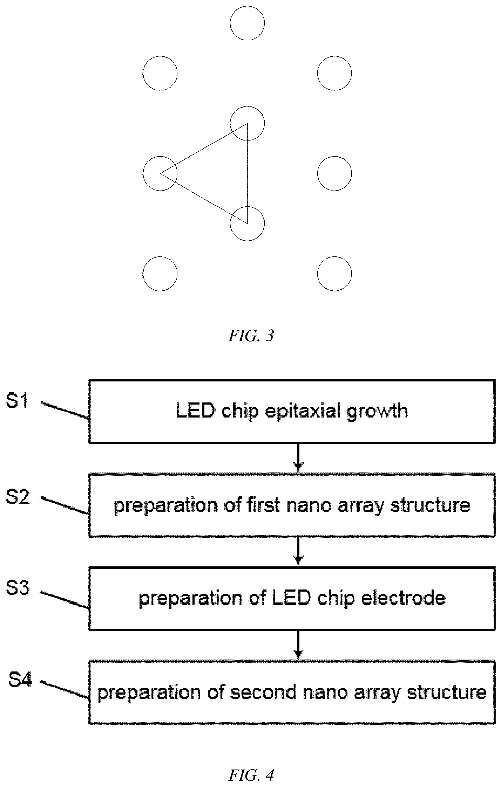

For the second solution provided by the present invention, it is provided a preparation method of inverted deep ultraviolet LED with double-layer photonic crystal structure, please refer to FIG. 4. It includes: the LED chip epitaxial growth S1, the preparation of first nano array structure S2, the preparation of LED chip electrode S3, the preparation of second nano array structure S4 and the package S5. Each step is described in detail below.

S1, the LED chip epitaxial growth. The specific steps are as follows: using the MOCVD method to sequentially deposit an AIN buffer layer (22), a superlattice layer (23), a N-type AIGaN electron transport layer (24), a quantum well active layer (25), and a P-type hole transport layer (26) and the P-type GaN contact layer (27) on a sapphire substrate (21) for obtaining the LED epitaxial wafer.

S2, the preparation of first nano array structure. The specific steps are as follows: using organic reagents and acid-base reagents, such as acetone, isopropanol, hydrochloric acid and sulfuric acid, to ultrasonically clean the surface of the P-type GaN contact layer (27) in the LED epitaxial wafer and drying. Coating the first photoresist, and using nano-imprint lithography to obtain a P-type GaN contact layer (27) with the first nano array structure (27a) that is uniform photonic crystal structure with large area. Etching the P-type GaN contact layer (27) with the first nano array structure (27a) by dry etching. In this embodiment, the first nano array structure (27a) is an array structure with a number of cylindrical grooves, the cylindrical grooves have a diameter of 200 ~ 400 nm and a depth of 150 ~ 250 nm, and the adjacent cylindrical grooves are arrayed in a regular triangle, and the distance between the centers of adjacent cylindrical grooves is 800 ~ 1500 nm. Preferably, the dry etching is plasma dry etching, and the first photoresist is PMMA, the etching gas is chlorine and boron trichloride, and the etching time is 1 to 2 min.

S3, the preparation of LED chip electrode. The specific steps are as follows: the LED epitaxial wafer with the first nano array structure (27a) is etched into a stepped surface, and then N-type and P-type electrodes are deposited, and an insulating protective layer is evaporated after annealing to obtain an LED chip with electrodes.

S4, the preparation of second nano array structure. The specific steps are as follows: using organic reagents, such as acetone, isopropanol, to ultrasonically clean the surface of the sapphire substrate (21) in the LED chip with electrodes and drying. Coating the second photoresist, and obtain a sapphire substrate (21) with the second nano array structure (21a) after exposure and development. Etching the sapphire substrate (21) with the second nano array structure (21a) by dry etching, and then striping the remaining photoresist and clean the surface with organic reagents to obtain a deep ultraviolet LED chip (2). In this embodiment, the second nano array structure (21a) is an array structure with a number of cylindrical grooves, the cylindrical grooves have a diameter of 450 ~ 750 nm and a depth of 500 ~ 1000 nm, and the adjacent cylindrical grooves are arrayed in a regular triangle, and the distance between the centers of adjacent cylindrical grooves is 800 ~ 1500 nm. Preferably, the dry etching is plasma dry etching, and the second photoresist is AZ4620; the etching gas is chlorine and boron trichloride, and the etching time is 3 to 5 min.

S5, the package. The specific steps are as follows: arranging the deep ultraviolet LED chip (2) at the bottom of the frame (1) in the reverse direction, and the sapphire substrate (21) with the second nano array (21a) structure is arranged away from the bottom of the frame (1); the lens (3) is arranged on the top of the frame (1) by solder paste or eutectic bonding, and the deep ultraviolet LED chip (2) is arranged in the closed space enclosed by the frame (1) and the lens (3), but no sealing material is filled in the frame (1); fixing the lens (3) on the frame (1) and focusing the light output angle of the deep ultraviolet LED chip (2) to obtain an inverted deep ultraviolet LED with double-layer photonic crystal structure.

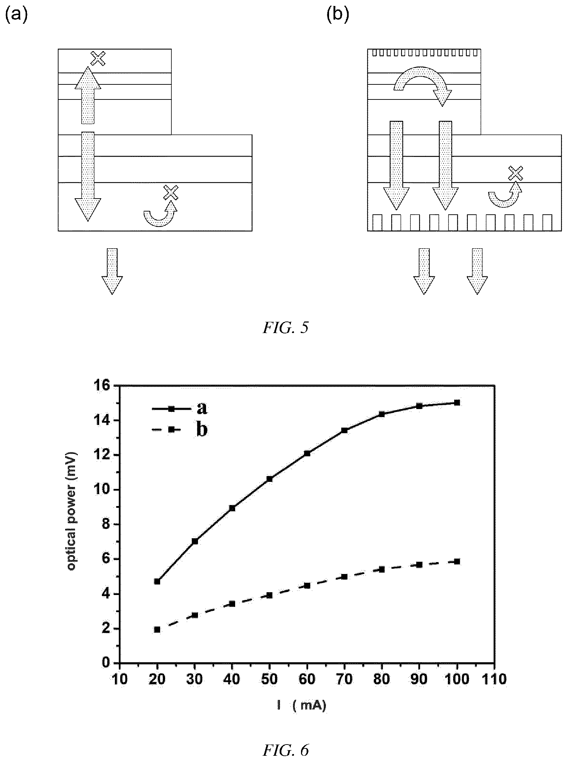

Further, the principle of enhanced light extraction of the flip-chip deep ultraviolet LED with the double-layer photonic crystal structure above will be described in detail. Please refer to FIG. 5. FIG. 5 is a schematic diagram of the light emission of the inverted deep ultraviolet LED with double-layer photonic crystal structure, where a is an ordinary deep-ultraviolet LED chip, and *b* is an inverted deep ultraviolet LED chip with double-layer photonic crystal structure. For the ordinary deep ultraviolet LED in a, the top and bottom of the chip are not arranged the nano-photonic crystal structure; when the active layer of the LED chip emits light, about 50% of the light will be absorbed by the GaN contact layer, and the actual light emitted from the sapphire substrate is less than 50%. For the inverted deep ultraviolet LED chip with double-layer photonic crystal structure in *b,* the first nano array structure and the second nano array structure are respectively arranged on the top and bottom of the chip, and a double-layer nano-photonic crystal structure is formed; under the action of the first nano array structure, about 50% of the light originally absorbed by the GaN contact layer is reflected and emitted from the sapphire substrate; while reducing the light absorption of the GaN contact layer, it also reduces the total reflection at the sapphire substrate, so that the overall light output power at the sapphire substrate is more than doubled. It breaks the upper limit of 50% light extraction efficiency in the existing technology, and makes the improvement of LED performance more potential in the future.

The light output power of the ordinary deep-ultraviolet LED and the inverted deep ultraviolet LED with double-layer photonic crystal structure are compared. The result is shown in FIG. 6, where line a is an inverted deep ultraviolet LED with double-layer photonic crystal structure, and line *b* is an ordinary deep ultraviolet LED. It can be seen from FIG. 6 that the light output power of the inverted deep ultraviolet LED with double-layer photonic crystal structure in the present invention is more than doubled compared with ordinary deep-ultraviolet LED. It is proved that the present invention effectively solves the problems of the strong absorption of deep ultraviolet light by the P-type GaN contact layer and the total reflection of deep ultraviolet light by the sapphire / air interface in the prior art.

In summary, the beneficial effect of the technical scheme proposed in the present invention is: by arranging the first nano array structure on the P-type GaN contact layer and the second nano array structure on the sapphire substrate of the deep ultraviolet LED, the existing upper limit of light extraction efficiency is broken, and the optical power of deep ultraviolet LED is more than doubled.

It is to be understood, however, that even though numerous characteristics and advantages of the present invention have been set forth in the foregoing description, together with details of the structure and function of the invention, the disclosure is illustrative only, and changes may be made in detail, especially in matters of shape, size, and arrangement of parts within the principles of the invention to the full extent indicated by the broad general meaning of the terms in which the appended claims are expressed.

## Claims

1. An inverted deep ultraviolet LED with double-layer photonic crystal structure, comprising a frame (1), a deep ultraviolet LED chip (2) and a lens (3), wherein;
the lens (3) is arranged on the top of the frame (1), and the deep ultraviolet LED chip (2) is arranged in a closed space enclosed by the frame (1) and the lens (3);
the deep ultraviolet LED chip (2) is arranged at the bottom of the frame (1), and a first nano array structure (27a) is arranged on the surface of the deep ultraviolet LED chip (2) near the bottom of the frame (1), and a second nano array structure (21a) is arranged on the surface of the deep ultraviolet LED chip (2) away from the bottom of the frame (1).

2. The inverted deep ultraviolet LED with double-layer photonic crystal structure according to claim 1, wherein the first nano array structure (27a) is an array structure with a number of cylindrical grooves, the cylindrical grooves have a diameter of 200 ~ 400 nm and a depth of 150 ~ 250 nm, and the adjacent cylindrical grooves are arrayed in a regular triangle, and the distance between the centers of adjacent cylindrical grooves is 800 ~ 1500 nm;
the second nano array structure (21a) is an array structure with a number of cylindrical grooves, the cylindrical grooves have a diameter of 450 ~ 750 nm and a depth of 500 ~ 1000 nm, and the adjacent cylindrical grooves are arrayed in a regular triangle, and the distance between the centers of adjacent cylindrical grooves is 800 ~ 1500 nm.

3. The inverted deep ultraviolet LED with double-layer photonic crystal structure according to claim 2, wherein the deep ultraviolet LED chip (2) includes a sapphire substrate (21), an AIN buffer layer (22), a superlattice layer (23), a N-type AIGaN electron transport layer (24), a quantum well active layer (25), a P-type hole transport layer (26), and a P-type GaN contact layer (27);
depositing the AIN buffer layer (22), the superlattice layer (23), the N-type AIGaN electron transport layer (24), the quantum well active layer (25), the P-type hole transport layer (26), and the P-type GaN contact layer (27) sequentially on the sapphire substrate (21);
the first nano array structure (27a) is arranged on the P-type GaN contact layer (27), and the second nano array structure (21a) is arranged on the sapphire substrate (21).

4. A preparation method of inverted deep ultraviolet LED with double-layer photonic crystal structure, including the following steps: the LED chip epitaxial growth, the preparation of first nano array structure, the preparation of LED chip electrode, the preparation of second nano array structure and the package;
the specific steps of the LED chip epitaxial growth include: using the MOCVD method to sequentially deposit an AIN buffer layer (22), a superlattice layer (23), a N-type AIGaN electron transport layer (24), a quantum well active layer (25), and a P-type hole transport layer (26) and the P-type GaN contact layer (27) on a sapphire substrate (21) for obtaining the LED epitaxial wafer;
the preparation method of inverted deep ultraviolet LED with double-layer photonic crystal structure is used to prepare the inverted deep ultraviolet LED with double-layer photonic crystal structure in claim 1.

5. The preparation method of inverted deep ultraviolet LED with double-layer photonic crystal structure according to claim 4, wherein the specific steps of the preparation of first nano array structure include:
using organic reagents and acid-base reagents to ultrasonically clean the surface of the P-type GaN contact layer (27) in the LED epitaxial wafer and drying;
coating the first photoresist, and using nano-imprint lithography to obtain a P-type GaN contact layer (27) with the first nano array structure (27a);
etching the P-type GaN contact layer (27) with the first nano array structure (27a) by dry etching.

6. The preparation method of inverted deep ultraviolet LED with double-layer photonic crystal structure according to claim 5, wherein the first nano array structure (27a) is an array structure with a number of cylindrical grooves, the cylindrical grooves have a diameter of 200 ~ 400 nm and a depth of 150 ~ 250 nm, and the adjacent cylindrical grooves are arrayed in a regular triangle, and the distance between the centers of adjacent cylindrical grooves is 800 ~ 1500 nm;
the dry etching is plasma dry etching, and the first photoresist is PMMA, the etching gas is chlorine and boron trichloride, and the etching time is 1 to 2 min.

7. The preparation method of inverted deep ultraviolet LED with double-layer photonic crystal structure according to claim 5, wherein the specific steps of the preparation of LED chip electrode include: the LED epitaxial wafer with the first nano array structure (27a) is etched into a stepped surface, and then N-type and P-type electrodes are deposited, and an insulating protective layer is evaporated after annealing to obtain an LED chip with electrodes.

8. The preparation method of inverted deep ultraviolet LED with double-layer photonic crystal structure according to claim 4, wherein the specific steps of the preparation of second nano array structure include:
using organic reagents to ultrasonically clean the surface of the sapphire substrate (21) in the LED chip with electrodes and drying;
coating the second photoresist, and obtain a sapphire substrate (21) with the second nano array structure (21a) after exposure and development;
etching the sapphire substrate (21) with the second nano array structure (21a) to obtain a deep ultraviolet LED chip (2) by dry etching.

9. The preparation method of inverted deep ultraviolet LED with double-layer photonic crystal structure according to claim 8, wherein the second nano array structure (21a) is an array structure with a number of cylindrical grooves, the cylindrical grooves have a diameter of 450 ~ 750 nm and a depth of 500 ~ 1000 nm, and the adjacent cylindrical grooves are arrayed in a regular triangle, and the distance between the centers of adjacent cylindrical grooves is 800 ~ 1500 nm;
the dry etching is plasma dry etching, and the second photoresist is AZ4620, the etching gas is chlorine and boron trichloride, and the etching time is 3 to 5 min.

10. The preparation method of inverted deep ultraviolet LED with double-layer photonic crystal structure according to claim 8, wherein the specific steps of the package include:
arranging the deep ultraviolet LED chip (2) at the bottom of the frame (1) in the reverse direction, and the sapphire substrate (21) with the second nano array structure (21a) is arranged away from the bottom of the frame (1);
the lens (3) is arranged on the top of the frame (1), and the deep ultraviolet LED chip (2) is arranged in the closed space enclosed by the frame (1) and the lens (3), to obtain an inverted deep ultraviolet LED with double-layer photonic crystal structure.
